# EUROPEAN PATENT APPLICATION

(11) **EP 2 317 564 A2**
(43) Date of publication of application: **04.05.2011**
(21) Application number: 09808383.5
(22) Date of filing: 17.08.2009
(51) Int. Cl.: H01L 31/042

(54) **SOLAR BATTERY MODULE AND METHOD FOR MANUFACTURING THE SAME**

(30) Priority: 19.08.2008 KR 20080081048
(71) Applicant: TG Solar Corporation, Gyeonggi-do 445-812 (KR)
(72) Inventor: LEE, Yoo Jin, Yongin-si Gyeonggi-do 448-550 (KR); KIM, Dong Jee, Seongnam-si Gyeonggi-do 463-909 (KR); JANG, Seok Pil, Suwon-si Gyeonggi-do 441-729 (KR); LEE, Young Ho, Yongin-si Gyeonggi-do 448-519 (KR); LEE, Byung Il, Seongnam-si Gyeonggi-do 463-804 (KR); JANG, Taek Yong, Suwon-si Gyeonggi-do 443-470 (KR)
(74) Representative: Samson & Partner
(86) International application number: PCT/KR2009/004589
(87) International publication number: WO 2010/021477

(57) **Abstract**

A solar cell mode and a method for manufacturing the same are disclosed. The solar battery module in accordance with the present invention includes a plurality of solar cells arranged in row and column directions; and a conductive ribbon electrically connecting the plurality of solar cells, wherein each of the solar cells has a structure in which a first photoelectric element including a polycrystalline semiconductor layer and a second photoelectric element including an amorphous semiconductor layer are stacked.

## Description

### Technical Field

The present invention relates to a solar cell mode and a method for manufacturing the same, and more particularly, to a solar battery module in which tandem type solar cells formed by stacking photoelectric elements are connected in series, and a method for manufacturing the same.

### Background Art

A general solar cell is a single junction type cell, and thus a large solar cell is required to produce a large amount of power. However, the increase of the area of the solar cell causes a limitation in its installation place, or the like, and an increase in its manufacturing cost.

Also, even in a solar cell having the excellent photoelectric conversion efficiency, among the single junction type solar cells, the photoelectric conversion efficiency is merely 20% or less, and a majority of light is transmitted as it is or reflected to be lost.

Thus, in order to overcome such a problem, a solar cell having a dual-junction type tandem structure in which photoelectric elements are stacked has been proposed. The tandem type solar cell can produce more electricity from the same substrate area, so it advantageously obtains an improved photoelectric conversion efficiency compared with the conventional single junction type solar cell.

For example, Saitoh et al. fabricated a p-i-n type amorphous silicon (a-Si)/microcrystalline Si (µc-Si) tandem type solar cell by using a plasma enhanced chemical vapor deposition (PECVD), in which an initial photoelectric conversion efficiency was 9.4% and a stabilized photoelectric conversion efficiency was 8.5% per 1cm².

However, in case of the tandem type silicon solar cell developed by Saitoh et al., when microcrystalline silicon is formed by using PECVD, the substrate is bent or a processing time is lengthened depending on the processing conditions of pressure and temperature.

In addition, because the tandem structure is a structure in which a plurality of thin film layers are stacked, the intensity of light significantly diminishes toward the lower layer due to reflection, refraction, or the like, which takes place between the layers, thus degrading the photoelectric conversion efficiency.

Moreover, in fabricating a solar battery module by connecting a plurality of solar cells, an additional process such as isolating solar cells, or the like, is required, thus complicating its manufacturing process and increasing its manufacturing cost of the solar battery module.

Also, in case where glass is used as a substrate of the solar cell, when the substrate is bent due to the high temperature process, a connection between the solar cells may be unstable, and worse, the solar cells may be disconnected in manufacturing the solar battery module by connecting the solar cells in series.

### Disclosure

### Technical Problem

It is, therefore, an object of the present invention to provide a solar battery module having solar cells with a tandem structure, which is capable of improving a photoelectric conversion efficiency by allowing each of stacked photoelectric elements to receive light of a different wavelength, and a method for manufacturing the same.

Another object of the present invention is to provide a solar battery module having solar cells with a tandem structure, which is capable of improving a photoelectric conversion efficiency by employing polycrystalline silicon with high quality, and a method for manufacturing the same.

Still another object of the present invention is to provide a solar battery module having solar cells with a tandem structure, which is capable of simplifying its manufacturing process and reducing its manufacturing cost by eliminating the necessity of a process of isolating solar cells, and a method for manufacturing the same.

Still another object of the present invention is to provide a solar battery module having solar cells with a tandem structure, which is capable of stabilizing the state of a series connection of solar cells by forming a substrate with a conductive and rigid metal or metal alloy, and a method for manufacturing the same.

### Technical Solution

In accordance with one aspect of the present invention, there is provided a solar battery module including: a plurality of solar cells arranged in row and column directions; and a conductive ribbon electrically connecting the plurality of solar cells, wherein each of the solar cells has a structure in which a first photoelectric element including a polycrystalline semiconductor layer and a second photoelectric element including an amorphous semiconductor layer are stacked.

Each of the solar cells includes: a substrate made of a conductive material; a first photoelectric element including a first polycrystalline semiconductor layer formed on the substrate, a second polycrystalline semiconductor layer formed on the first polycrystalline semiconductor layer, and a third polycrystalline semiconductor layer formed on the second polycrystalline semiconductor layer; a second photoelectric element including a first amorphous semiconductor layer formed on the third polycrystalline semiconductor layer, a second amorphous semiconductor layer formed on the first amorphous semiconductor layer, and a third amorphous semiconductor layer formed on the second amorphous semiconductor layer; an upper electrode formed on the third amorphous semiconductor layer; and a plurality of grid electrodes formed on the upper electrode in one direction.

In accordance with another aspect of the present invention, there is provided a method for fabricating a solar battery module, the method including: (a) forming a plurality of solar cells to have a structure in which a first photoelectric element including a polycrystalline semiconductor layer and a second photoelectric element including an amorphous semiconductor layer are stacked; and (b) electrically connecting the plurality of solar cells by a conductive ribbon.

The forming each of solar cells includes: (a1) forming a first lower amorphous semiconductor layer on a substrate made of a conductive material; (a2) forming a second lower amorphous semiconductor layer on the first lower amorphous semiconductor layer; (a3) forming a third lower amorphous semiconductor layer on the second lower amorphous semiconductor layer; (a4) crystallizing the first to third lower amorphous semiconductor layers into first to third polycrystalline semiconductor layers; (a5) forming a first upper amorphous semiconductor layer on the third polycrystalline semiconductor layer; (a6) forming a second upper amorphous semiconductor layer on the first upper amorphous semiconductor layer; (a7) forming a third upper amorphous semiconductor layer on the second upper amorphous semiconductor layer; (a8) forming an upper electrode on the third upper amorphous semiconductor layer; and (a9) forming a plurality of grid electrodes on the upper electrode in one direction.

### Advantageous Effects

In accordance with the present invention, a solar cell having a dual structure of a polycrystalline silicon photoelectric element and an amorphous silicon photoelectric element is provided, thereby receiving light of various wavelengths to thus improve a photoelectric conversion efficiency of the solar cell.

In addition, in accordance with the present invention, because a polycrystalline silicon having excellent crystallinity (namely, having high quality) is used, a photoelectric conversion efficiency of the solar cell can be improved.

Also, in accordance with the present invention, because a process of isolating solar cells in fabricating a solar battery module is not required, its manufacturing process can be simplified and its manufacturing cost can be reduced.

Moreover, in accordance with the present invention, because a substrate is formed of a conductive and rigid metal or metal alloy, a stable series connection can be obtained between solar cells.

### Description of Drawings

The above and other objects and features of the present invention will become apparent from the following description of the preferred embodiments given in conjunction with the accompanying drawings, in which:
Fig. 1 is an exploded view of a solar battery module in accordance with an embodiment of the present invention;
Fig. 2 is a simple plan view showing a connection state of solar cells of Fig. 1;
Fig. 3 is a side view of Fig. 2;
Figs. 4 to 8 are views showing the constitution of a method for fabricating a solar cell in accordance with an embodiment of the present invention; and
Fig. 9 is a simple plan view showing a connection of a conductive ribbon to the solar cell of Fig. 8.

### Best Mode for the Invention

The foregoing and other objects, technical constitutions, and advantages of the present invention will become more apparent from the following detailed description of the present invention when taken in conjunction with the accompanying drawings.

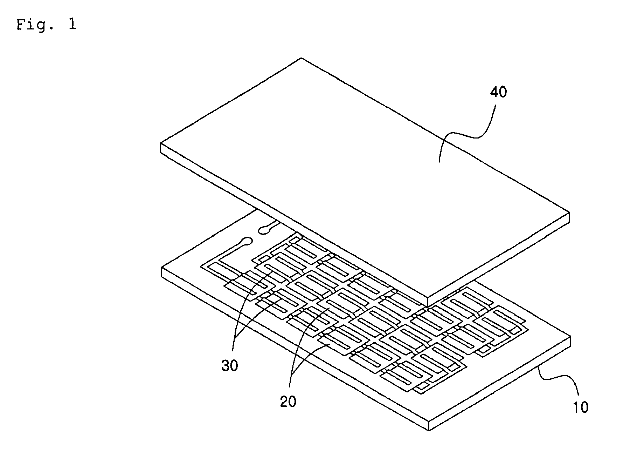

Fig. 1 is an exploded view of a solar battery module in accordance with an embodiment of the present invention.

Referring to Fig. 1, a solar battery module in accordance with an embodiment of the present invention has a matrix structure in which a plurality of solar cells 20 are positioned in row and column directions on a main substrate 10.

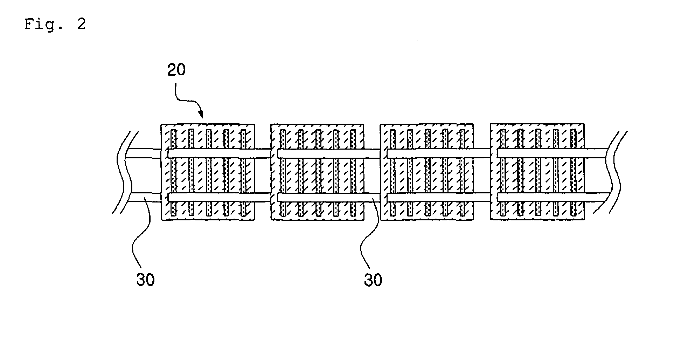

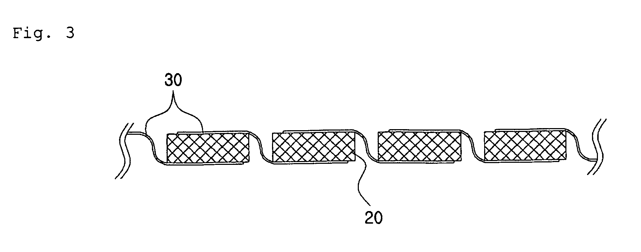

The plurality of solar cells 20 are electrically connected in series by a plurality of conductive ribbons 30 to implement a solar battery module obtaining a required voltage, details of which will be described with reference to Figs. 2 and 3.

A transparent protection substrate 40 allowing light to be transmitted therethrough is formed on the main substrate 10 including the plurality of solar cells 20 to protect the solar cells 20.

In this case, a protection layer (not shown) is formed between the main substrate 10 and the solar cell 20 or between the solar cells 20 and the protection substrate 40 to further protect the solar cells 20 positioned in the interior against a bad factor such as a physical impact applied from outside or moisture.

The protection layer may be a buffer member made of a transparent material. Preferably, the protection layer may be made of an EVA (ethylene vinyl acetate) resin having adhesive property.

Although the above description has been made with respect to the structure in which the protection layers are formed on upper and lower portions of the solar cell 20, the protection layer may be formed by filling a resin between the main substrate 10 and the protection substrate 40.

Fig. 2 is a simple plan view showing a connection state of the solar cells of Fig. 1.

Fig. 3 is a side view of Fig. 2.

Referring to Figs. 2 and 3, the plurality of solar cells 20 are electrically connected in series in a manner that one side of the conductive ribbon 30 is connected to an upper portion of one solar cell 20, and the other side of the conductive ribbon 30 is connected to a lower portion of another solar cell 20 neighboring one solar cell 20 in one direction.

In this case, the conductive ribbon 30 as a single line may be used to connect the solar cells 20, but two or more conductive ribbons 30 may be used to connect the solar cells 20, as shown in the drawings, in order to prevent the occurrence of a disconnection deficiency.

Meanwhile, the solar cells 20 are formed to have a tandem structure, in which a first photoelectric element including a polycrystalline semiconductor layer and a second photoelectric element including an amorphous semiconductor layer are stacked, and are connected in series to improve a photoelectric conversion efficiency. The solar cells 20 may be obtained through the following fabrication process.

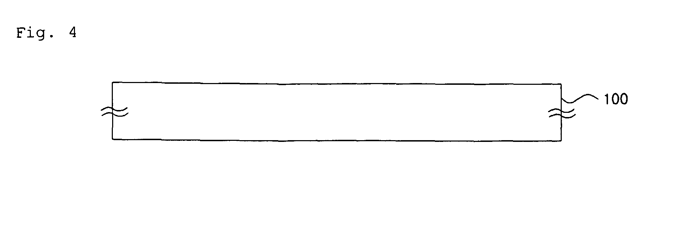

Figs. 4 to 8 are views showing the constitution of a method for fabricating a solar cell in accordance with an embodiment of the present invention.

Referring to Fig. 4, a substrate 100 is first prepared. The substrate 100 may be made of a known conductive material without any limitations. In this case, preferably, a metal or a metal alloy having a similar coefficient of thermal expansion to that of silicon while having rigidity tolerating a bending phenomenon of the substrate 100 in a follow-up high temperature crystallization process may be used. For example, the substrate 100 may be made of stainless steel (SUS), molybdenum (Mo), tungsten (W), molybdenum tungsten (MoW), Invar (Fe-Ni alloy), and the like.

In this case, a surface of the substrate 100 may be textured. Here, a texturing refers to roughing the surface of the substrate, namely, forming protrusion and depression patterns on the surface of the substrate in order to prevent degradation of a photoelectric conversion efficiency by an optical loss caused by a reflection of light incident onto the surface of the substrate of a solar cell. When the surface of the substrate is textured to be rough, the light once reflected from the surface of the substrate is reflected again to reduce reflectance of light, thus increasing a capturing amount of light to improve the photoelectric conversion efficiency of the solar cell.

Meanwhile, a lower electrode (not shown) made of a conductive material may be additionally formed on the substrate 100. The lower electrode may be made of a material which has a low contact resistance and electrical characteristics not degraded although a high temperature process is performed. Namely, the material of the lower electrode may be preferably one of molybdenum (Mo), tungsten (W), molybdenum tungsten (MoW), or an alloy thereof, but is not necessarily limited thereto. The material of the lower electrode may include general conducive materials, such as copper, aluminum, titanium, and the like, or an alloy thereof. Also, the material of the lower electrode may include a transparent conducting oxide (TCO). A method for forming the lower electrode may include a physical vapor deposition (PVD) such as a thermal evaporation, an E-beam evaporation, or a sputtering, and a chemical vapor deposition (CVD) such as a low pressure chemical vapor deposition (LPCVD), a plasma enhanced chemical vapor deposition (PECVD), a metal organic chemical vapor deposition (MOCVD).

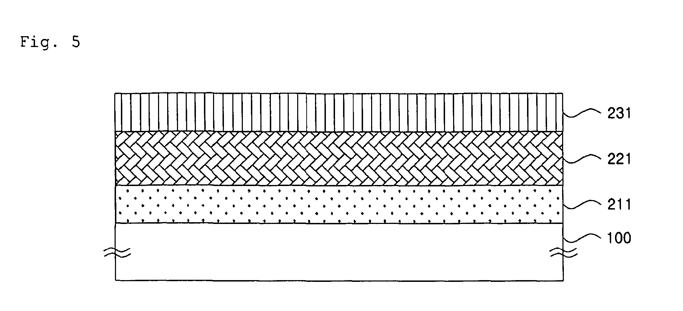

Referring to Fig. 5, three silicon layers 211, 221, and 231 are formed on the substrate 100. More specifically, a first lower amorphous silicon layer 211 is formed on the substrate 100, a second lower amorphous silicon layer 221 is formed on the first lower amorphous silicon layer 211, and then a third lower amorphous silicon layer 231 is formed on the second lower amorphous silicon layer 221 to constitute one photoelectric element. In this case, the first, second, and third lower amorphous silicon layers 211, 221, and 231 may be formed by using CVD such as PECVD or LPCVD.

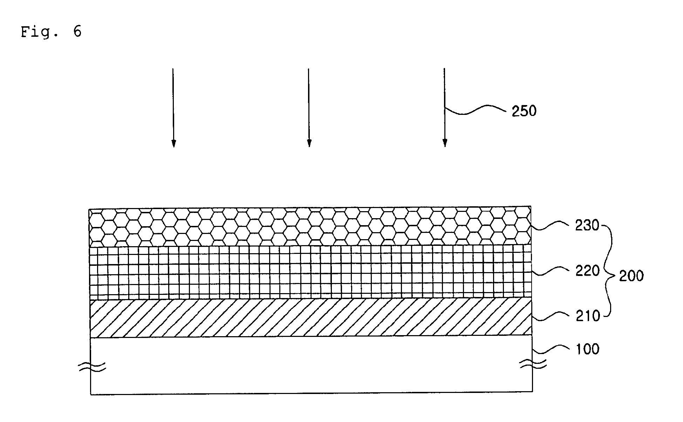

Next, referring to Fig. 6, the first, second, and third lower amorphous silicon layers 211, 221, and 231 are crystallized (250). Namely, the first lower amorphous silicon layer 211 is crystallized into a first polycrystalline silicon layer 210, the second lower amorphous silicon layer 221 is crystallized into a second polycrystalline silicon layer 220, and the third lower amorphous silicon layer 231 is crystallized into a third polycrystalline silicon layer 230.

As a result, a first photoelectric element 200 including the first, second, and third polycrystalline silicon layers 210, 220, and 230 is formed on the substrate 100. The first photoelectric element 200 may have a structure of a p-i-n diode in which p, i, and n type polycrystalline silicon layers are sequentially stacked, which can produce power with photoelectron-motive force generated as light is received. Here, the i type polycrystalline silicon layer refers to an intrinsic silicon layer without impurities doped therein. In n type or p type doping, impurities may be preferably doped through an in situ method in forming the amorphous silicon layer. In general, boron (B) is used as an impurity in p type doping and phosphor (P) or arsenic (As) is used as an impurity in n type doping, but the present invention is not limited thereto and a known technique may be used without any limitations.

As a method for crystallizing (250) the amorphous silicon layers 211, 221, and 231, any one of solid phase crystallization (SPC), excimer laser annealing (ELA), sequential lateral solidification (SLS), metal induced crystallization (MIC), and metal induced lateral crystallization (MILC) may be used. The method for crystallizing amorphous silicon is well-known in the art, so a detailed description thereof will be omitted.

Meanwhile, in the above description, the first, second, and third lower amorphous silicon layers 211, 221, and 231 are all formed and then simultaneously crystallized, but the present invention is not necessarily limited thereto. For example, a crystallization process may be separately performed for each of the lower amorphous silicon layers, or two lower amorphous silicon layers may be simultaneously crystallized while the other remaining lower amorphous silicon layer may be separately crystallized.

In addition, a defect removing process may be additionally performed on the first to third polycrystalline silicon layers 210, 220, and 230 in order to further improve the general characteristics of the polycrystalline silicon layers. In the present invention, the polycrystalline silicon layers may be thermally treated at a high temperature or hydrogen plasma treated to remove defects (e.g., impurities, dangling bonds, etc.) present in the polycrystalline silicon layers.

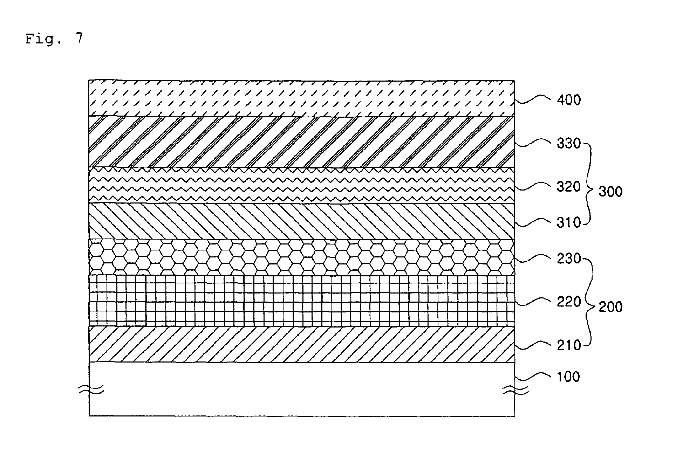

Next, referring to Fig. 7, three amorphous silicon layers 310, 320, and 330 may be additionally formed on the first photoelectric element 200. More specifically, the first upper amorphous silicon layer 310 may be formed on the third polycrystalline silicon layer 230, the second upper amorphous silicon layer 320 may be formed on the first upper amorphous silicon layer 310, and then the third upper amorphous silicon layer 330 may be formed on the second upper amorphous silicon layer 320, to constitute a second photoelectric element 300 having a p-i-n diode structure like the first photoelectric element 200. In this case, the first to third amorphous silicon layers 310, 320, and 330 may be formed by using CVD such as PECVD or LPCVD.

Next, an upper electrode 400, which is a transparent conductor, is formed on the third upper amorphous silicon layer 330. The upper electrode 400 may be preferably made of any one of indium tin oxide (ITO), zinc oxide (ZnO), indium zinc oxide (IZO), and FSO (SnO:F) obtained by doping a small amount of F in SnO, but the present invention is not limited thereto. A method for forming the upper electrode 400 may include PVD such as a sputtering, or the like, and CVD such as LPCVD, PECVD, MOCVD, or the like.

Meanwhile, although not shown, a connection layer, which is a transparent conductor, may be additionally formed on the third polycrystalline silicon layer 230. The connection layer forms a tunnel junction between the third polycrystalline silicon layer 230 and the first upper amorphous silicon layer 310 to obtain a better photoelectric conversion efficiency of the solar cell. At this time, the connection layer may be preferably made of AZO (ZnO:Al) obtained by adding a small amount of Al to ZnO, but the present invention is not limed thereto, and a general transparent conductive material such as ITO, ZnO, IZO, FSO (SnO:F), or the like may be used.

In this manner, the solar cell 20 having the tandem structure including the first photoelectric element 200 consisting of the polycrystalline silicon layers 210, 220 and 230 and the second photoelectric element 300 consisting of the amorphous silicon layers 310, 320 and 330 can be obtained. In this case, because the first photoelectric element 200 includes the polycrystalline silicon layers 210, 220 and 230, it has good photoelectric conversion efficiency over light of a long wavelength band, and because the second photoelectric element 300 includes the amorphous silicon layers 310, 320 and 330, it has good photoelectric conversion efficiency over light of a short wavelength band. Thus, the tandem type solar cell in accordance with the present embodiment can absorb light of various wavelength bands, thereby improving the photoelectric conversion efficiency.

In addition, because the tandem type solar cell in accordance with the present embodiment employs the high quality polycrystalline silicon, it has excellent aging characteristics (namely, aging is slow) compared with the conventional tandem type solar cell employing microcrystalline silicon. Namely, in terms of the characteristics of silicon, the amorphous silicon has not good aging characteristics and, unlike the microcrystalline silicon, the polycrystalline silicon has little amorphous silicon in its microstructure, so the characteristics of the tandem type solar cell in accordance with the present invention are not easily degraded during the use.

In the present invention, preferably, the structure of the first and second photoelectric elements 200 and 300 may have four types of conductivity arrangements as follows. Hereinbelow, + and - indicate a relative difference of a doping density, and + has a higher doping density than -. For example, n+ is doped with higher density than n-. Also, if there is no indication of + or -, it means that there is no particular limitation in the doping density.

First, the first to third polycrystalline silicon layers 210 to 230 may have n, i, and p conductivity types, respectively, and the first to third upper amorphous silicon layers 310 to 330 may have n, i, and p conductivity types, respectively. In this case, preferably, the first to third polycrystalline silicon layers 210 to 230 have n+, i, and p+ conductivity types, respectively.

Second, the first to third polycrystalline silicon layers 210 to 230 may have n, n, and p conductivity types, respectively, and the first to third upper amorphous silicon layers 310 to 330 may have n, i, and p conductivity types, respectively. In this case, preferably, the first to third polycrystalline silicon layers 210 to 230 have n+, n-, and p+ conductivity types, respectively.

Third, the first to third polycrystalline silicon layers 210 to 230 may have p, i, and n conductivity types, respectively, and the first to third upper amorphous silicon layers 310 to 330 may have p, i, and n conductivity types, respectively. In this case, preferably, the first to third polycrystalline silicon layers 210 to 230 have p+, i, and n+ conductivity types, respectively.

Fourth, the first to third polycrystalline silicon layers 210 to 230 may have p, p, and n conductivity types, respectively, and the first to third upper amorphous silicon layers 310 to 330 may have p, i, and n conductivity types, respectively. In this case, preferably, the first to third polycrystalline silicon layers 210 to 230 have p+, p-, and n+ conductivity types, respectively.

The tandem structure in which the first and second photoelectric elements 200 and 300 are stacked has been described as an example, but if necessary, the photoelectric elements may be dual-stacked or more, and p-n type, rather than p-i-n type, may be used.

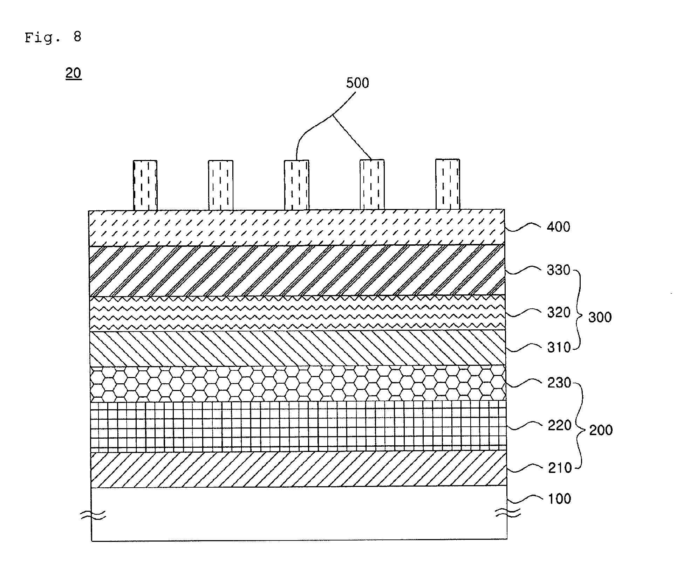

Next, referring to Fig. 8, a plurality of grid electrodes 500 are formed on the upper electrode 400 in one direction. The grid electrodes 500 serve to easily collect current from a surface of the upper electrode 400 of the solar cell 20. The grid electrodes 500 may be made of a conductive material, and generally, it is made of Al or Ni/Al. Because the area on which the grid electrodes 500 are formed does not absorb solar light, the grid electrodes 500 may be preferably formed to be spaced apart from each other in order to increase an area for receiving light. In this case, the number and width of the grid electrodes 500 may vary depending on design criteria.

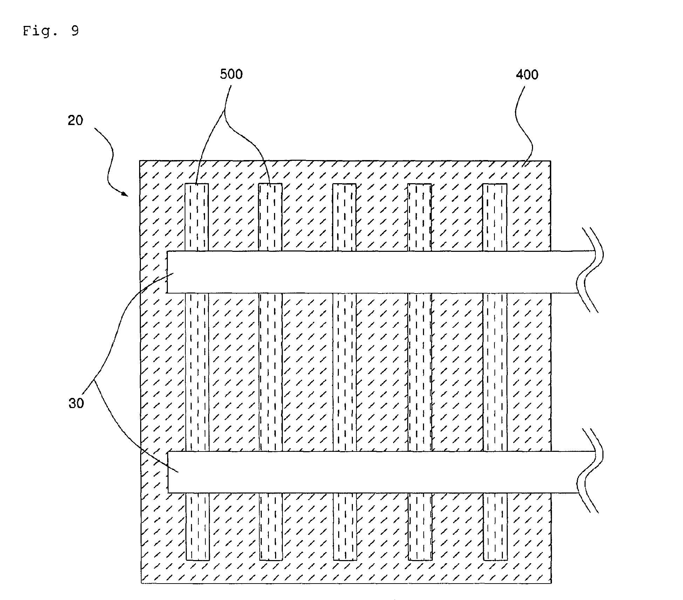

Fig. 9 is a simple plan view showing a connection of a conductive ribbon to the solar cell of Fig. 8.

Referring to Fig. 9, the grid electrodes 500 are formed in one direction, e.g., a column direction on the upper electrode 400. However, the grid electrodes 500 may be formed in a row direction. In this case, the grid electrodes 500 are electrically connected in series to a substrate of a different solar cell that neighbors the solar cell in one direction by the conductive ribbon 30.

In this manner, in the present invention, the solar cell having the tandem structure formed on the single substrate is a unit solar cell (namely, a solar cell) required for fabricating a solar battery module by itself, and the solar battery module including the solar cell having the tandem structure is fabricated by connecting a plurality of the solar cells in series by the conductive ribbon. Thus, in the present embodiment, a process of forming a unit solar cell which is essentially added in the conventional process of fabricating a solar battery module (namely, a process of isolating unit solar cells by etching multiple layers constituting a solar cell by using a laser scribing method, or the like) can be omitted. As a result, in accordance with the present invention, a manufacturing process of the solar battery module can be simplified and thus its manufacturing cost can be reduced.

In addition, in accordance with the present invention, because the substrate 100 is formed of conductive and rigid metal or metal alloy that can endure a bending phenomenon at a high temperature, the series connection state of solar cells can be stably maintained.

While the present invention has been described with respect to certain preferred embodiments, it will be apparent to those skilled in the art that various changes and modifications may be made without departing from the scope of the invention as defined in the following claims.

## Claims

1. A solar battery module comprising:
a plurality of solar cells arranged in row and column directions; and
a conductive ribbon electrically connecting the plurality of solar cells,
wherein each of the solar cells has a structure in which a first photoelectric element including a polycrystalline semiconductor layer and a second photoelectric element including an amorphous semiconductor layer are stacked.

2. The solar battery module of claim 1, wherein each of the solar cells comprises:
a substrate made of a conductive material;
a first photoelectric element including a first polycrystalline semiconductor layer formed on the substrate, a second polycrystalline semiconductor layer formed on the first polycrystalline semiconductor layer, and a third polycrystalline semiconductor layer formed on the second polycrystalline semiconductor layer;
a second photoelectric element including a first amorphous semiconductor layer formed on the third polycrystalline semiconductor layer, a second amorphous semiconductor layer formed on the first amorphous semiconductor layer, and a third amorphous semiconductor layer formed on the second amorphous semiconductor layer;
an upper electrode formed on the third amorphous semiconductor layer; and
a plurality of grid electrodes formed on the upper electrode in one direction.

3. The solar battery module of claim 2, wherein the grid electrodes are connected with a substrate of a different solar cell that neighbors the solar cell in one direction by the conductive ribbon.

4. The solar battery module of claim 2, wherein a lower electrode made of a conductive material is further formed on the substrate.

5. The solar battery module of claim 4, wherein the lower electrode is any one of transparent conducting oxide (TCO), molybdenum (Mo), tungsten (W), and molybdenum tungsten (MoW).

6. The solar battery module of claim 2, wherein the substrate is a metal or a metal alloy.

7. The solar battery module of claim 2, wherein the upper electrode is made of a transparent conductive material.

8. The solar battery module of claim 2, further comprising:
a connection layer made of a transparent conductive material between the third polycrystalline semiconductor layer and the first amorphous semiconductor layer.

9. The solar battery module of claim 7 or 8, wherein the transparent conductive material includes indium tin oxide (ITO), zinc oxide (ZnO), indium zinc oxide (IZO), FSO (SnO:F), and AZO (ZnO:Al).

10. The solar battery module of claim 2, wherein each of the first to third polycrystalline semiconductor layers is crystallized through any one of solid phase crystallization (SPC), excimer laser annealing (ELA), sequential lateral solidification (SLS), metal induced crystallization (MIC), and metal induced lateral crystallization (MILC).

11. The solar battery module of claim 2, wherein each of the first to third polycrystalline semiconductor layers is a polycrystalline silicon layer, and each of the first and third amorphous semiconductor layers is an amorphous silicon layer.

12. A method for manufacturing a solar battery module, the method comprising:
(a) forming a plurality of solar cells to have a structure in which a first photoelectric element including a polycrystalline semiconductor layer and a second photoelectric element including an amorphous semiconductor layer are stacked; and
(b) electrically connecting the plurality of solar cells by a conductive ribbon.

13. The method of claim 12, wherein said forming each of the solar cells comprises:
(a1) forming a first lower amorphous semiconductor layer on a substrate made of a conductive material;
(a2) forming a second lower amorphous semiconductor layer on the first lower amorphous semiconductor layer;
(a3) forming a third lower amorphous semiconductor layer on the second lower amorphous semiconductor layer;
(a4) crystallizing the first to third lower amorphous semiconductor layers into first to third polycrystalline semiconductor layers;
(a5) forming a first upper amorphous semiconductor layer on the third polycrystalline semiconductor layer;
(a6) forming a second upper amorphous semiconductor layer on the first upper amorphous semiconductor layer;
(a7) forming a third upper amorphous semiconductor layer on the second upper amorphous semiconductor layer;
(a8) forming an upper electrode on the third upper amorphous semiconductor layer; and
(a9) forming a plurality of grid electrodes on the upper electrode in one direction.

14. The method of claim 13, further comprising:
forming a lower electrode made of a conductive material on the substrate.

15. The method of claim 13, further comprising:
forming a connection layer made of a transparent conductive material between the third polycrystalline semiconductor layer and the first amorphous semiconductor layer.

16. The method of claim 13, wherein said crystallizing is performed through any one of solid phase crystallization (SPC), excimer laser annealing (ELA), sequential lateral solidification (SLS), metal induced crystallization (MIC), and metal induced lateral crystallization (MILC).

17. The method of claim 13, wherein each of the first to third polycrystalline semiconductor layers is a polycrystalline silicon layer, and each of the first and third upper amorphous semiconductor layers is an amorphous silicon layer.
